# EUROPEAN PATENT APPLICATION

(11) **EP 1 732 370 A2**
(43) Date of publication of application: **13.12.2006**
(21) Application number: 05023681.9
(22) Date of filing: 28.10.2005
(51) Int. Cl.: H05K 1/00, H05K 1/03, H05K 3/00

(54) **Carrier tape for temporarily mounting flexible printed circuits**

(30) Priority: 10.06.2005 KR 2005049528
(71) Applicant: Korea Taconic Co., Ltd., Seongnam-Si, Gyeonggi-Do 463-827 (KR)
(72) Inventor: Lim, Yong-Mook, 803-1504, Hyundai Apart., Gyeonggi-Do 463-827 (KR)
(74) Representative: Merkle, Gebhard

(57) **Abstract**

The present invention discloses a carrier tape for mounting a flexible printed circuit (FPC). The carrier tape comprises at least one fabric (1) selected from the group consisting of a glass fiber fabric impregnated with fluororesin, a carbon fiber fabric and an aromatic polyamide fiber fabric; a composite silicon rubber coating layer (2) coated on one surface of the fabric (1); and a heat resistant silicon adhesive coating layer (3) coated on the other surface of the fabric. The carrier tape of the present invention exhibits excellent shape stability, peelability, and adhesive force even at high temperature, has an even surface, leaves no adhesive residues, and is easy to wash in case of surface contamination. Due to this, the carrier tape of the present invention enables attachment of the entire surface of a flexible printed circuit (FPC) thereto, can easily attach and detach a flexible printed circuit (FPC) repeatedly, and is extended in service life because it can be used repeatedly.

## Description

### TECHNICAL FIELD

The present invention relates to a carrier tape for mounting a flexible printed circuit (hereinafter refer to as "FPC"), and more particularly to a carrier tape for mounting an FPC which is excellent in shape stability, peelability and adhesive force even at high temperature, has an even surface, leaves no adhesive residues, and is easy to wash in case of surface contamination.

A carrier tape for mounting an FPC is disposed and used on a carrier plate so as to temporarily secure and fix an FPC on the carrier plate, which is a glass fiber plate or metal plate, in an SMT (Surface Mounting Technology) process in which a semiconductor device such as a diode is mounted on an FPC or in a soldering process in which a semiconductor device mounted on an FPC is soldered with lead.

Therefore, it is necessary that a carrier tape for mounting an FPC be capable of attaching and securing the entire surface of an FPC thereto repeatedly and enables easy attachment and detachment of a temporarily secured FPC.

### BACKGROUND ART

Up to now, as a carrier tape for mounting an FPC, polyimide tapes have commonly been used. However, in this case, they cannot be used repeatedly, and thus polyimide tapes have to be attached to and removed from a carrier plate on each operation, which makes the process complicated and increases manufacturing costs.

Moreover, in the case of using a polyimide tape, the FPC is contaminated due to adhesive residues, and the entire surface of the FPC cannot be evenly secured, thus lowering the printing precision.

To solve the aforementioned problems, there was proposed a method in which sticky resin, such as silicon resin, is coated on a carrier plate. However, there were problems that an FPC is folded and bent when attached due to a low dimensional stability, that the fixation property of the FPC is lowered due to the deviation in coating thickness of the adhesive resin, and that a coating is peeled off or corrugated during the process due to a low heat resistance.

As another prior art carrier tape for mounting an FPC, there was proposed a carrier tape which is manufactured by laminating a mesh over a polyester fabric and then coating an adhesive thereupon. In this case, however, the dimensional stability is low and the thickness is irregular.

Accordingly, it is an object of the present invention to overcome those prior art problems and provide a carrier tape for mounting an FPC which can be used repeatedly and can attach the entire surface of an FPC, allows easy attachment and detachment of the FPC, leaves no adhesive residues, and is easy to wash in case of surface contamination.

### DISCLOSURE OF THE INVENTION

### (TECHNICAL OBJECTIVE)

The present invention provides a carrier tape for mounting an FPC which can attach the entire surface of an FPC of a thin film thereto because of superior shape stability and even surface roughness.

Furthermore, the present invention provides a carrier tape for mounting an FPC which enables easy attachment and detachment of an FPC repeatedly due to excellent heat resistance, shape stability, adhesive force and peelability, and is extended in service life because it can be used repeatedly.

### (TECHNICAL MEANS FOR SOLVING THE PROBLEMS)

To achieve the above objects, there is provided a carrier tape for mounting an FPC according to the present invention, comprising: at least one fabric (1) selected from the group consisting of a glass fiber fabric impregnated with fluororesin, a carbon fiber fabric and an aromatic polyamide fiber fabric; a composite silicon rubber coating layer (2) coated on one surface of the fabric (1); and a heat resistant silicon adhesive coating layer (3) coated on the other surface of the fabric.

Hereinafter, the present invention will be descried in detail with reference to the accompanying drawings.

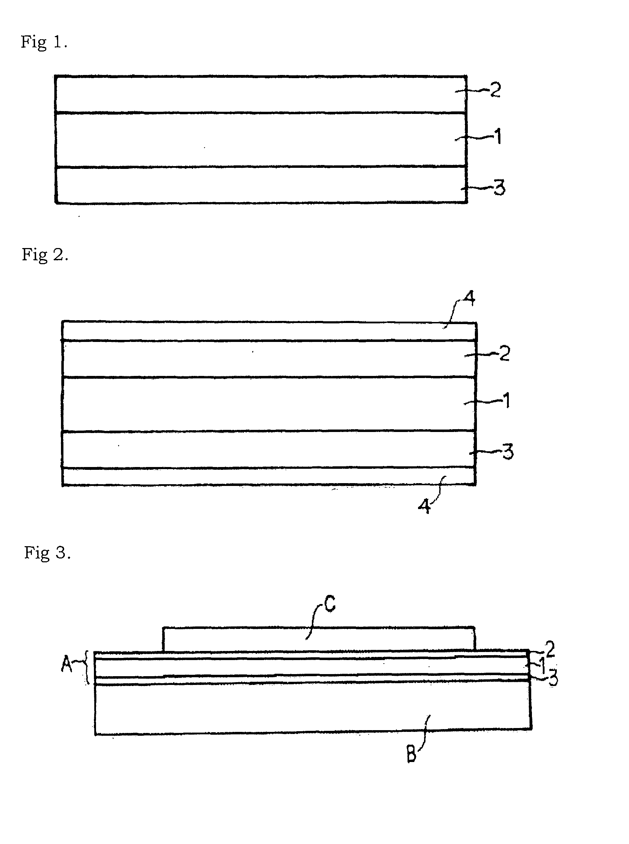

The carrier tape of the present invention has a sectional structure as shown in Fig. 1, in which a composite silicon rubber coating layer 2 is formed on one surface of a fabric (hereinafter, referred to simply as "fabric") selected from the group consisting of a glass fiber fabric impregnated with fluororesin, a carbon fiber fabric and an aromatic polyamide fiber fabric, and a heat resistant silicon adhesive coating layer 3 is formed on the other surface of the fabric.

Fig. 1 is a cross sectional view of the present invention.

More concretely, the present invention is of a structure wherein a composite silicon rubber is coated on one of both surfaces of the fabric 1 impregnated with fluororesin, and a heat resistant silicon adhesive is coated on the other surface of the fabric.

The fluororesin includes polytetrafluoroethylene (PTFE) resin or the like.

The composite silicon rubber is made by adding a curing agent and a filler, such as silica, to a polysiloxane silicon polymer and then heating and curing the mixture under a catalyst, and the hardness preferably ranges from 5 to 60 shores.

Meanwhile, the heat resistant silicon adhesive has sufficient heat resistance to maintain consistent adhesive physical properties even at temperatures higher than 250°C.

It is more preferable for the improvement of adhesiveness with a carrier plate (B) to etch or plasma-treat the surface of the heat resistant silicon adhesive coating layer 2.

In addition, the carrier tape of the present invention comprises a structure in which the composite silicon rubber coating layer 2 and the heat resistant silicon adhesive coating 3 are covered with a protective film 4 as shown in Fig. 2.

Fig. 2 is a cross sectional view of the carrier tape of the present invention including a protective film 4.

The protective film 4 serves to protect the coating layers 2 and 3 before use and is separated from the coating layers 2 and 3 when the coating layers 2 and 3 are to be used.

In the case that the present invention is used for an SMT process or the like, as shown in Fig. 3, the heat resistant silicon adhesive coating layer 3 is bonded to the carrier plate (B), and an FPC (A) is attached to and detached from the composite silicon rubber coating layer 3.

Fig. 3 is a cross sectional view showing a state wherein the present invention is used for an SMT process.

### ADVANTAGEOUS EFECTS

Since the carrier tape of this invention comprises the above fabric 1 impregnated with fluororesin which exhibits excellent heat resistance and shape stability, there occurs no shrinkage, expansion and deformation even at a temperature of 260°C or so, thereby enabling repeated use.

In addition, the carrier tape of this invention produces no residues of an adhesive when attached and detached because the heat resistant silicon adhesive coating layer 3 to be bonded to the carrier plate (B) has an excellent heat resistance.

Moreover, the carrier tape of this invention enables attachment and detachment of an FPC repeatedly about 500 times at 260°C, since the portion where the FPC is bonded, attached, and detached is formed of the composite silicon rubber coating layer 2, can attach the entire surface of the FPC thereto because the surface is even, and can be washed simply with ethanol or the like in case of surface contamination.

The carrier tape of this invention enables attachment of the entire surface of an FPC of a thin film thereto because it is excellent in shape stability even at a high temperature and has an even surface roughness.

Further, the carrier tape of this invention enables repeated attachment and detachment of an FPC thereto because it exhibits excellent heat resistance, shape stability, adhesive force and peelability, and has a long service life because it can be used repeatedly.

### BRIEF DESCRIPTION OF THE DRAWINGS

Figs. 1 and 2 are cross sectional views of a carrier tape for mounting a flexible printed circuit (FPC) according to the present invention;
Fig. 3 is a cross sectional view showing a state wherein the carrier tape for mounting a flexible printed circuit (FPC) according to the present invention is used.

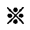 Explanation of Reference Numerals for Main Parts of the Drawings
1: glass fiber fabric impregnated with fluororesin, carbon fiber fabric, or aromatic polyamide fiber fabric
2: composite silicon rubber coating layer
3: heat resistant silicon adhesive coating layer
4: protective film

A: carrier tape of the present invention
B: carrier plate
C: flexible printed circuit (FPC)

### INDUSTRIAL APPLICABILITY

The carrier tape of the present invention is disposed and used on a carrier plate in order to temporarily secure and fix an FPC on a carrier plate, which is a glass fiber plate or metal plate, in an SMT process or the like in which a semiconductor device such as a diode is mounted on an FPC.

The carrier tape of the present invention may be disposed and used on a carrier plate in order to temporarily secure and fix an rigid printed circuits on a carrier plate, which is a glass fiber plate or metal plate, in the process of mounting a semiconductor device such as a diode on the rigid printed circuits.

The carrier tape of the present invention may also be disposed and used on a carrier plate in order to temporarily secure and fix an flip chip on a carrier plate in the chip mounting process, and in order to temporarily secure and fix flat display materials such as an Organic Light Emitting Device (OLED) and Liquid Crystal panels in the manufacturing process.

## Claims

1. A carrier tape for mounting an FPC, comprising:
at least one fabric (1) selected from the group consisting of a glass fiber fabric impregnated with fluororesin, a carbon fiber fabric and an aromatic polyamide fiber fabric;
a composite silicon rubber coating layer (2) coated on one surface of the fabric (1); and
a heat resistant silicon adhesive coating layer (3) coated on the other surface of the fabric (1).

2. The carrier tape of claim 1, wherein the fluororesin is polytetrafluoroethylene (PTFE) resin.

3. The carrier tape of claim 1, wherein the composite silicon rubber is made by adding a curing agent and a filler to a polysiloxane silicon polymer and then heating and curing the mixture under a catalyst.

4. The carrier tape of claim 1, wherein the hardness of the composite silicon rubber ranges from 5 to 60 shores.

5. The carrier tape of claim 1, wherein the heat resistant silicon adhesive maintains consistent adhesive physical properties even at temperatures higher than 250 °C.

6. The carrier tape of claim 1, wherein the surface of the heat resistant silicon adhesive coating layer (2) is etched or plasma-treated.

7. The carrier tape of claim 1, wherein the composite silicon rubber coating layer (2) and the heat resistant silicon adhesive coating layer (3) are covered with a protective film (4).

8. The carrier tape of claim 7, wherein the protective film (4) is a polyester film.
